# EUROPÄISCHE PATENTSCHRIFT

(11) **EP 0 464 239 B1**
(45) Veröffentlichungstag und Bekanntmachung des Hinweises auf die Patenterteilung: **27.11.1996**
(21) Anmeldenummer: 90112711.8
(22) Anmeldetag: 03.07.1990
(51) Int. Cl.: H03K 19/00

(54) **Querstromfreie C-MOS-Verstärkerschaltung**
CMOS amplifier circuit free of through current
Circuit amplificateur CMOS exempt de courant transversal

(43) Veröffentlichungstag der Anmeldung: 08.01.1992
(73) Patentinhaber: SIEMENS AKTIENGESELLSCHAFT, 80333 München (DE)
(72) Erfinder: Eberhard, Günther, Dipl.-Phys., D-8031 Eichenau (DE); Jähnig, Manfred, Dipl.-Ing., D-8120 Ottobrunn (DE)

(56) Entgegenhaltungen:
- EP-A- 0 258 808
- EP-A- 0 344 604

## Beschreibung

Die Erfindung betrifft eine querstromfreie C-MOS-Verstärkerschaltung für digitale Signale gemäß dem Oberbegriff des Anspruchs 1.

Aus Tietze Schenk Halbleiterschaltungstechnik, 8. Auflage 1986, S.211ff sind Verstärkerschaltungen bekannt. Abbildung 9.36 auf Seite 212 zeigt eine invertierende C-MOS-Treiberstufe bestehend aus einem n-Kanal-Feldeffekttransistor und einem p-Kanal-Feldeffekttransistor. Dabei ist die Source-Elektrode des n-Kanal-Feldeffekttransistors an Masse und die des p-Kanal-Feldeffekttransistors an der Betriebsspannung V_{DD} angeschlossen. Der Drainanschluß des n-Kanal-Feldeffekttransistors ist zum einen mit dem Drainanschluß des p-Kanal-Feldeffekttransistors verbunden und zum anderen mit einer Ausgangsklemme. Beide Gateanschlüsse der Feldeffekttransistoren sind miteinander verbunden und führen zu einer Eingangsklemme.

Beide Feldeffekttransistoren arbeiten also in Sourceschaltung und verstärken die Eingangsspannung invertierend. Dabei stellt jeweils der eine Transistor den Arbeitswiderstand für den anderen dar. Legt man an die Eingangsklemme eine Spannung von Uₑ = 0 an, so leitet der p-Kanal-Feldeffekttransistor und der n-Kanal-Feldeffekttransistor sperrt. Die Ausgangsspannung wird so gleich der Betriebsspannung V_{DD}. Für eine Eingangsspannung Uₑ = V_{DD} sperrt der p-Kanal-Feldeffekttransistor und der n-Kanal-Feldeffekttransistor leitet. Die Ausgangsspannung wird nun zu Null. Im stationären Zustand fließt also kein Strom. Lediglich während des Umschaltens fließt ein kleiner Querstrom, solange sich die Eingangsspannung in einem mittleren Bereich befindet.

Die Stromaufnahme eines C-MOS-Gatters setzt sich aus drei Anteilen zusammen: Wenn die Eingangsspannung konstant gleich Null oder gleich V_{DD} ist, fließt nur ein kleiner Sperrstrom im nano- bis µ-Ampere-Bereich je nach Größe bzw. Treiberleitung des Gatters. Wenn das Eingangssignal seinen Zustand wechselt, fließt vorübergehend ein Querstrom durch beide Transistoren. Außerdem müssen die Schaltkapazitaten aufgeladen werden, wenn der Ausgang auf High-Potential geht. Die bei einem Low-High-Low-Zyklus aufgrund beider Effekte transportierte Ladung laßt sich mit Hilfe einer fiktiven "Verlustleistungskapazität" C_{X} beschreiben. Die Verlustleistung ist demnach proportional zur Frequenz, mit der die Schaltung betrieben wird.

Eine in der Figur 2 dargestellte C-MOS-Verstarkerschaltung ist in der europaischen Patentanmeldung EP-A-0 344 604 beschrieben und bildet den Ausgangspunkt der Erfindung.

Gemäß der Erfindung wird eine Verstärkerschaltung mit den Merkmalen des Anspruchs 1 vorgeschlagen. In den abhängigen Ansprüchen sind besondere Ausführungsarten der Erfindung angegeben.

Die Erfindung wird nachfolgend anhand von vier Figuren näher beschrieben. Es zeigen:
- Figur 1: eine Prinzipschaltungsanordnung einer C-MOS-Verstarkerstufe,
- Figur 2: ein Ausführungsbeispiel zur Ansteuerung einer C-MOS-Leistungsendstufe,
- Figur 3: ein erstes Ausführungsbeispiel einer Ansteuerschaltung der Verstärkerschaltung gemäß der Erfindung,
- Figur 4: ein zweites Ausführungsbeispiel einer Ansteuerschaltung der Verstärkerschaltung gemäß der Erfindung.

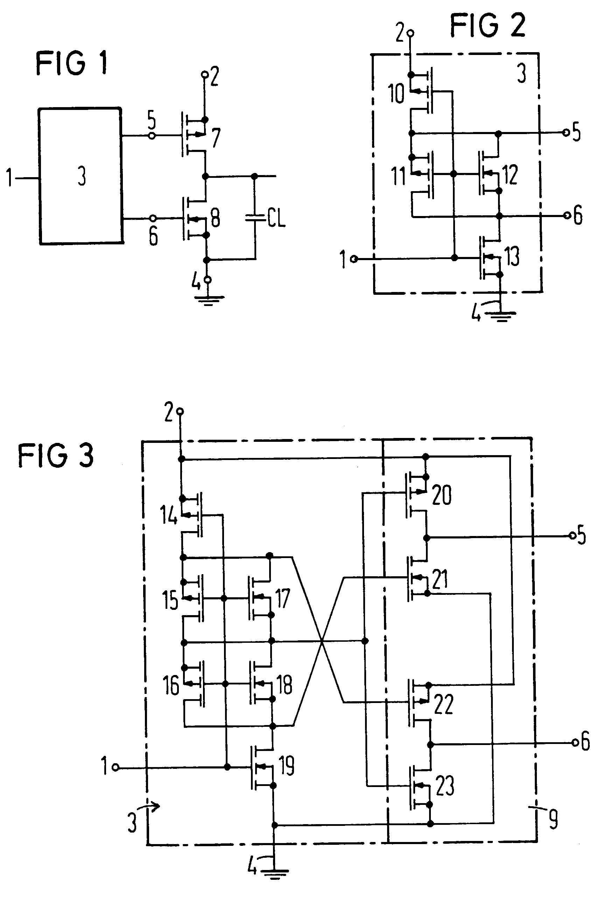

Figur 1 zeigt eine C-MOS-Leistungsendstufe, bestehend aus einem p-Kanal-Feldeffekttransistor 7 und einem n-Kanal-Feldeffekttransistor 8. Die Laststrecken der C-MOS-Transistoren 7, 8 sind zwischen Versorgungsspannungsklemme 2 und Masseanschluß 4 in Reihe geschaltet. Die Gateanschlüsse der Transistoren 7, 8 sind über Anschlußklemmen 5, 6 mit den beiden Ausgängen der Ansteuerschaltung 3 verbunden. Die Ansteuerschaltung 3 besitzt einen Eingang 1. Die Reihenschaltung der beiden Laststrecken der Transistoren 7, 8 ist mit einem Mittelabgriff versehen, der den Verstarkerausgang bildet, der über eine kapazitive Last C_{L} mit Masse verbunden ist.

Wesentlich ist, daß sich die Leistungstransistoren 7, 8 niemals gleichzeitig im leitenden Zustand befinden. Dasselbe gilt für alle komplementär aufgebauten Verstärkerstufen, die in der Ansteuerschaltung 3 enthalten sind. Die Ansteuerschaltung wertet das Eingangssignal am Eingang 1 folgendermaßen aus: Ausgehend von einem stationären Zustand soll am Eingang 1 der Ansteuerschaltung ein "Low"-Pegel anliegen. An beiden Ausgängen der Ansteuerschaltung 5, 6 liegt somit ein "High"-Pegel an. Der p-Kanal-Feldeffekttransistor 7 sperrt und der n-Kanal-Feldeffekttransistor 8 befindet sich im leitenden Zustand. Am Ausgang der Endstufe und damit an der kapazitiven Last C_{L} liegt somit ein "Low"-Pegel an.

Geht der Signalzustand am Eingang 1 nun von "Low" auf "High" über, so erzeugt die Ansteuerschaltung 3 zuerst eine Pegeländerung des Signals am Ausgang 6 von "High" nach- "Low". Nun sperren beide Leistungstransistoren 7, 8. Anschließend steuert die Ansteuerschaltung 3 den Pegel am Ausgang 5 von "High" nach "Low" und steuert den Transistor 7 somit leitend. Am Ausgang der Endstufe und somit an der kapazitiven Last C_{L} liegt nun ein "High"Pegel an.

Geht der Pegel am Eingang 1 von "High" wieder nach "Low", so steuert die Ansteuerschaltung 3 die Ausgangsignale 5, 6 derart, daß zuerst der Transistor 7 gesperrt und anschließend der Transistor 8 leitend geschaltet wird.

Eine derartige Ansteuerung gilt auch für alle in der Ansteuerschaltung 3 enthaltenen komplementären Treiberstufen. Auf diese Weise werden Querströme sicher vermieden.

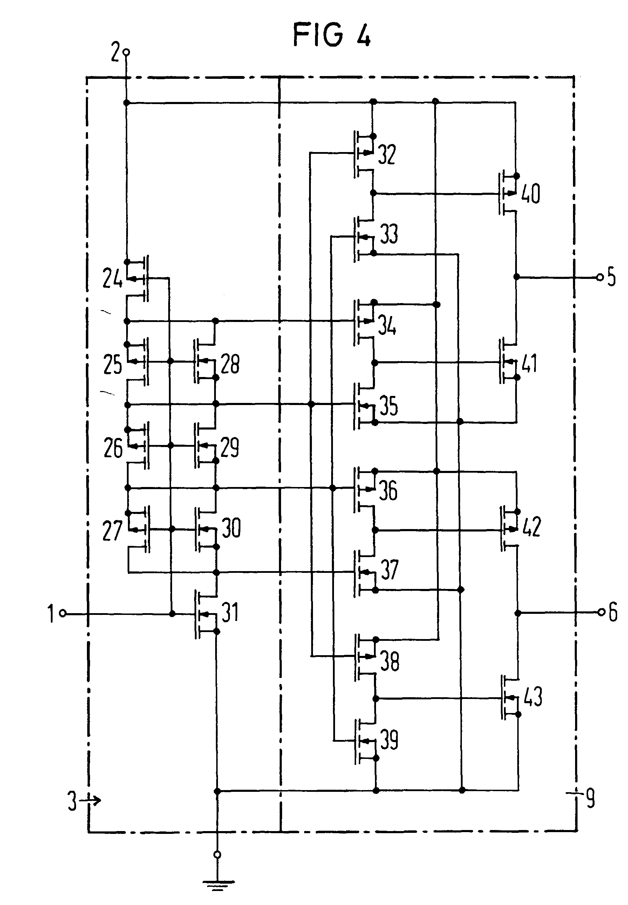

Eine bekannte Ansteuerschaltung 3 gemäß FIG 2 enthält jeweils zwei n-Kanal- und zwei p-Kanal-Feldeffekttransistoren. Diese sind derart verschaltet, daß der Eingang 1 mit allen Gate-anschlüssen der Feldeffekttransistoren 10, 11; 12, 13 verbunden ist. Jeweils die Laststrecken der n-Kanal- und der p-Kanal-Feldeffekttransistoren 10, 11; 12, 13 sind in Reine geschaltet. Der Source-Anschluß des ersten n-Kanal-Feldeffekttransistors 13 ist mit Masse und der Sourceanschluß des ersten p-Kanal-Feldeffekttransistors 10 ist mit dem Versorgungsspannungsanschluß 2 verbunden. Die Reihenschaltung der Laststrecken der p-Kanal-Feldeffekttransistoren 10, 11 ist mit einem Mittelabgriff versehen, der mit dem Drainanschluß des zweiten n-Kanal-Feldeffekttransistors 12 und mit der Ausgangsklemme 5 verbunden ist. Desgleichen weist die Reiherschaltung der Laststrecken der n-Kanal-Feldeffekttransistoren einen Mittelabgriff auf, der zum einen mit dem Drain-Anschluß des zweiten p-Kanal-Feldeffekttransistors 11 und mit der Ausgangsklemme 6 verschaltet ist.

Bei einer "Low"-Signal am Eingang sperren im stationären Zustand beide n-Kanal-Transistoren 12, 13 und beide p-Kanal-Feldeffekttransistoren 10, 11 leiten. Dadurch liegt an den Ausgangsklemmen 5, 6 ein "High"-Pejel an. Bei einem Zustandswechsel des zu verstärkenden Signals am Eingang 1 von "Low" nach "High" sperrt zuerst Transistor 11, dann geht Transistor 13 in den leitenden und Transistor 10 in den sperrenden Zustand über und zuletzt wird Transistor 12 leitend geschaltet. Auf diese Weise geht zuerst der Signalzustand am Ausgang 6 und dann am Ausgang 5 nach "Low". Bei einem Signalwechsel von "High" nach "Low" am Eingang 1 wird zuerst Transistor 12 gesperrt, danach wird Transistor 10 in den leitenden und Transistor 13 in den sperrenden Zustand geschaltet und zuletzt Transistor 11 leitend geschaltet. In diesem Fall geht zuerst der Pegel am Ausgang 5 und anscnließend der Pegel am Ausgang 6 von "Low" nach "High".

Eine erfindungsgemäße Ansteuerschaltung in FIG 3 weist eine Verzögerungsstufe und eine nachgeschaltete Treiberstufe 9 auf. Die Verzögerungsstufe gemäß FIG 2 ist hier um jeweils einen p-Kanal- und einen n-Kanal-Feldeffekttransistor erweitert. Alle Gateanschlüsse der Feldeffekttransistoren sind wiederum miteinander verbunden und werden mit der Eingangsklemme 1 verschaltet. Die Reihenschaltungen der Laststrecken der drei p-Kanal-bzw. drei n-Kanal-Feldeffekttransistoren ist mit Mittelabgriffen versehen. Der erste Mittelabgriff zwischen erstem und zweitem p-Kanal-Feldeffekttransistor 14, 15 ist mit dem Drainanschluß des n-Kanal-Feldeffekttransistors 17 verbunden. Der zweite Mittelabgriff zwischen zweitem und drittem p-Kanal-Feldeffekttransistor 15, 16 ist mit dem zweiten Mittelabgriff zwischen zweitem und drittem n-Kanal-Feldeffekttransistor 18, 17 verbunden. Der Drainanschluß des dritten p-Kanal-Feldeffekttransistors 16 ist mit dem ersten Mittelabgriff zwischen erstem und zweitem n-Kanal-Feldeffekttransistor 19, 18 verschaltet. Die Treiberstufe 9 besteht aus zwei Verstärkerstufen, die jeweils aus zwei komplementären Feldeffekttransistoren 20, 21; 22, 23 aufgebaut sind. Die Laststrecken der Feldeffekttransistoren 20, 21; 22, 23 jeder Verstärkerstufe sind zwischen dem Versorgungsspannunganschluß 2 und dem Masseanschluß 4 in Reihe geschaltet. Die Reihenschaltung der Laststrecken weisen jeweils einen Mittelabgriff auf, die zu den Ausgängen 5, 6 führen. Der Gateanschluß des p-Kanal-Transistors 20 der ersten Verstärkerstufe ist zum einen mit dem Gateanschluß des n-Kanal-Transistors 23 der zweiten Verstärkerstufe und zum anderen mit dem zweiten Mittelabgriff der Reihenschaltung der Laststrecken der n-Kanal-Feldeffekttransistoren 17, 18 verbunden. Der Gateanschluß des n-Kanal-Transistors 21 der ersten Verstärkerstufe ist mit dem ersten Mittelabgriff der Reihenschaltung der Laststrecken der n-Kanal-Transistoren 18, 19 verschaltet. Der Gateanschluß des p-Kanal-Transistors 22 der zweiten Verstärkerstufe ist mit dem Drainanschluß des n-Kanal-Transistors 17 verbunden.

FIG 4 zeigt eine dreistufige Ansteuerschaltung, wobei die Verzögerungsstufe aus jeweils vier n-Kanal- und vier p-Kanal-Transistoren gebildet wird. Diese sind entsprechend FIG 2 bzw. FIG 3 verschaltet. Die Verzögerungsstufe erzeugt vier Ausgangssignale, die jeweils an den Drainanschlüssen des ersten bis vierten n-Kanal-Feldeffekttransistors abgreifbar sind. Die Treiberstufe 9 ist zweistufig ausgelegt. Die erste Stufe besteht aus vier Verstärkerstufen mit den acht Feldeffekttransistoren 32.... 39, deren Laststrecken entsprechend den Verstärkerstufen 20, 21; 22, 23 aus FIG 3 verschaltet sind. Das erste Ausgangssignal der Verzögerungsstufe wird dem Gateanschluß des n-Kanal-Feldeffekttransistors 37 und das vierte Ausgangssignal dem p-Kanal-Transistor 34 der dritten Stufe zugeführt. Das zweite Ausgangsignal der Verzögerungsstufe wird dem n-Kanal-Transistor 39, dem p-Kanal-Transistor 36 und dem n-Kanal-Transistor 33 zugeführt. Das dritte Ausgangssignal der Verzögerungsstufe wird dem p-Kanal-Transistor 38, dem n-Kanal-Transistor 35 und dem p-Kanal-Transistor 32 zugeführt. Die vier Ausgangssignale der ersten Stufe werden jeweils an den Mittelabgriffen der Reihenschaltungen der Laststrecken der Transistoren abgegriffen. Die zweite Stufe der Treiberstufe besteht aus zwei weiteren den übrigen Verstärkerstufen entsprechenden Verstärkerstufen 40, 41; 42, 43, deren Ausgangssignale den Ausgangsklemmen 5, 6 zugeführt werden. Das erste Ausgangssignal der ersten Stufe wird dem Gateanschluß des n-Kanal-Transistors 43 und das zweite Ausgangssignal der ersten Stufe dem Gateanschluß des p-Kanal-Transistors 42 zugeführt. Dementsprechend wird das dritte Ausgangssignal der ersten Stufe dem Gateanschluß des n-Kanal-Transistors 41 und das vierte Ausgangssignal dem Gateanschluß des p-Kanal-Transistors 40 zugeführt.

Bei den in FIG 3 und FIG 4 gezeigten Ausführungsbeispielen ist folgende Reihenfolge der Umschaltzeitpunkte der Ausgangssignale der Verzögerungsstufe gewährleistet:
Bei einem Signalwechsel am Eingang 1 von "Low" nach "High" wechselt das Potential an demjenigen Knotenpunkt zuerst, der am nächsten zum Masseanschluß liegt. Bei einem Signalwechsel von "High" nach "Low" am Eingang 1 ist eine entsprechend umgekehrte Reihenfolge gewährleistet. Die Treiberstufen 20 ...23; 32 ....43 werden nun mit den Ausgangssignalen der Verzögerungsstufe so angesteuert, daß ein gleichzeitig leitender Zustand der komplementären Transistoren einer Verstärkerstufe vermieden wird. Entsprechendes gilt für eventuell nachgeschaltete Verstärkerstufen. Die erfindungsgemäßen Schaltungen können beliebig zu mehrstufigen Verstärkerschaltungen erweitert werden.

Die erfindungsgemäße Schaltungsanordnung ist für alle integrierten Schaltungen in C-MOS-Technik geeignet, insbesondere, wo hohe kapazitive Lasten wie beispielsweise bei internen Clocktreibern oder Bustreibern vorkommen.

## Patentansprüche

1. Querstromfreie C-MOS-Verstarkerschaltung für digitale Signale mit einer Leistungsendstufe, bestehend aus zwei komplementären Feldeffekttransistoren (7, 8), deren Laststrecken in Reihe zwischen einem Versorgungsspannungsanschluß (2) und einem Masseanschluß (4) geschaltet sind und deren Reihenschaltung mit einem Mittelabgriff versehen ist, an den eine Last (C_{L}) anschließbar ist, mit
einer Ansteuerschaltung (3), mit einem Eingang (1), dem das zu verstärkende Signal zugeführt wird und einem ersten und zweiten Ausgang (5, 6), die jeweils mit einem Gateanschluß der Endstufentransistoren verbunden sind, wobei
die Ansteuerschaltung (3) eine Verzögerungsschaltung mit jeweils zwei Feldeffekttransistoren (14, 16; 17, 19; 24, 27; 28, 31) vom n- und p-Kanal-Typ enthält, deren Gateanschlüsse mit dem Eingang verbunden sind, wobei
die Laststrecken der n-Kanal-Feldeffekttransistoren (17, 19; 28, 31) in Reihe geschaltet sind und der Sourceanschluß eines ersten der n-Kanal-Feldeffekttransistoren (19; 31) mit Masse verbunden ist, wobei
die Laststrecken der p-Kanal-Feldeffekttransistoren (14, 16; 24, 27) in Reihe geschaltet sind und der Sourceanschluß eines ersten der p-Kanal-Feldeffekttransistoren (14; 24) mit dem Versorgungsspannungsanschluß (2) verbunden ist und wobei
die Drainanschlüsse des ersten p-Kanal-Feldeffekttransistors (14 ; 24) und des zweiten n-Kanal-Feldeffekttransistors (17 ; 28) der beiden Reihenschaltungen mit einem ersten Schaltungsknoten und die Drainanschlüsse des zweiten p-Kanal-Feldeffekttransistors (16 ; 27) und des ersten n-Kanal-Feldeffekttransistors (19 ; 31) der Reihenschaltungen mit einem zweiten Schaltungsknoten verbunden sind,
**dadurch gekennzeichnet, daß**
- die Reihenschaltungen der n- und p-Kanal-Feldeffekttransistoren der Verzögerungsschaltung mit mindestens jeweils einem weiteren Feldeffekttransistor (15, 18; 25, 26, 29, 30) des entsprechenden Kanaltyps gebildet werden, wobei die Laststrecken der weiteren Feldeffekttransistoren jeweils zwischen der Laststrecken der beiden p-Kanal- bzw. n-Kanal-Feldeffekttransistoren geschaltet sind und wobei jeweils die Drainanschlüsse von einem Paar der weiteren Feldeffekttransistoren des n- und p-Kanal-Typs einem weiteren Schaltungsknoten zugeführt werden,
- die Gateanschlüsse der weiteren Feldeffekttransistoren (15, 18; 25, 26, 29, 30) mit dem Eingang (1) verbunden sind,
- eine Treiberstufe (9) vorgesehen ist, die zwischen die Verzögerungsschaltung und die Leistungsendstufe (7, 8) geschaltet ist,
- die Treiberstufe (9) aus Verstärkerstufen (20, 21, 22, 23; 32...39) aufgebaut ist, die jeweils aus zwei komplementären Feldeffekttransistoren aufgebaut sind, deren Laststrecken in Reihe zwischen dem Versorgungsspannung (2) und dem Masseanschluß (4) geschaltet sind und deren Reihenschaltung mit einem Mittelabgriff versehen ist, wobei die Mittelabgriffe jeweils mit einem der ersten und zweiten Ausgänge (5, 6) der Ansteuerschaltung gekoppelt sind,
- jeder Feldeffekttransistor einer jeden Verstärkerstufe jeweils von einem verschiedenen Schaltungsknoten der ersten, zweiten und weiteren der Schaltungsknoten angesteuert wird derart, daß beim Umschalten der Feldeffekttransistoren jeder Verstärkerstufe und der Leistungsendstufe zuerst der zum Umschaltzeitpunkt leitende Feldeffektransistor gesperrt und dann der zum Umschaltzeitpunkt sperrende Feldeffekttransistor leitend geschaltet wird.

2. Querstromfreie C-MOS-Verstärkerschaltung nach Anspruch 1, **dadurch gekennzeichnet**, daß in der Treiberstufe (9) der Gateanschluß des p-Kanal-Feldeffekttransistors einer Verstärkerstufe mit dem Drainanschluß eines n-Kanal-Feldeffekttransistors der Verzögerungsschaltung (3) und der Gateanschluß des n-Kanal-Feldeffekttransistors derselben Verstärkerstufe mit dem Sourceanschluß des oben genannten n-Kanal-Feldeffekttransistors verbunden sind.

3. Querstromfreie C-MOS-Verstärkerschaltung nach Anspruch 2, **dadurch gekennzeichnet**, daß je zwei Ausgänge der Treiberstufe (9) mit den Eingängen einer nachgeschalteten weiteren Treiberstufe (40...43) verbunden sind.

## Claims

1. Leakage-current free CMOS amplifier circuit for digital signals with a power end stage consisting of two complementary field-effect transistors (7, 8) whose load paths are connected in series between a supply voltage terminal (2) and an earth terminal (4) and whose series connection is provided with a centre tap to which a load (C_{L}) can be connected, with a control circuit (3) having an input (1) to which the signal to be amplified is fed, and a first and second output (5, 6) which are each connected to a gate terminal of the end-stage transistors, the control circuit (3) containing a time-delay circuit with in each case two field-effect transistors (14, 16; 17, 19; 24, 27; 28, 31) of then-channel and p-channel types, the gate electrodes of which are connected to the input, the load paths of the n-channel field-effect transistors (17, 19; 28, 31) being connected in series and the source electrode of a first of the n-channel field-effect transistors (19, 13) being earthed, the load paths of the p-channel field-effect transistors (14, 16; 24, 27) being connected in series and the source electrode of a first of the p-channel field-effect transistors (14; 24) being connected to the supply voltage terminal (2), and the drain electrodes of the first p-channel field-effect transistor (14; 24) and of the second n-channel field-effect transistor (17; 28) of the two series connections being connected to a first circuit node and the drain electrodes of the second p-channel field-effect transistor (16; 27) -and of the first n-channel field-effect transistor (19; 31) of the series connections being connected to a second circuit node, characterized in that
- the series connections of the n-channel and p-channel field-effect transistors of the time-delay circuit are formed with at least in each case one further field-effect transistor (15, 18; 25, 26, 29, 30) of the corresponding channel type, the load paths of the further field-effect transistors each being connected between the load paths of the two p-channel or n-channel field-effect transistors, and the drain electrodes of a pair of the further field-effect transistors of the n-channel and p-channel type in each case being connected to a further circuit node,
- the gate electrodes of the further field-effect transistors (15, 18; 25, 26, 29, 30) being connected to the input (1),
- a driver stage (9) being provided, which is connected between the time-delay circuit and the power end stage (7, 8)
- the driver stage (9) is constructed from amplifier stages (20, 21, 22, 23; 32...39) which are each constructed from two complementary field-effect transistors whose load paths are connected in series between the supply voltage (2) and the earth terminal (4) and whose series connection is provided with a centre tap, the centre taps being in each case coupled to one of the first and second outputs (5, 6) of the control circuit,
- each field-effect transistor of each one of the amplifier stages being in each case controlled by a different circuit node of the first, second and further circuit nodes, in such a way that, when the field-effect transistors of each amplifier stage and the power end stage are switched over, the field-effect transistor which is on at the switch-over time is turned off and the field-effect- transistor which is off at the switch-over time is then turned on.

2. Leakage-current free CMOS amplifier circuit according to Claim 1, characterized in that, in the driver stage (9), the gate electrode of the p-channel field-effect transistor of one amplifier stage is connected to the drain electrode of an n-channel field-effect transistor of the time-delay circuit (3), and the gate electrode of then-channel field-effect transistor of the same amplifier stage is connected to the source electrode of the abovementioned n-channel field-effect transistor.

3. Leakage-current free CMOS amplifier circuit according to Claim 2, characterized in that each pair of outputs of the driver stage (9) are connected to the inputs of a downstream-connected further driver stage (40...43).

## Revendications

1. Circuit amplificateur CMOS exempt de courant transversal pour des signaux numériques, comportant un étage final de puissance constitué de deux transistors à effet de champ (7, 8) complémentaires, dont les voies de charge sont branchées en série entre une borne de tension d'alimentation (2) et une borne de masse (4) et dont le circuit série est muni d'une prise médiane à laquelle une charge (C_{L}) peut être raccordée,
un circuit de commande (3) comportant une entrée (1) à laquelle le signal à amplifier est envoyé et une première et une seconde sorties (5, 6) qui sont reliées chacune à une borne de grille des transistors de l'étage final,
le circuit de commande (3) comportant un étage de retard avec respectivement deux transistors à effet de champ (14, 16 ; 17, 19 ; 24, 27 ; 28, 31) dont les canaux sont de type n et p et dont les bornes de grille sont reliées à l'entrée,
les voies de charge des transistors à effet de champ à canal n (17, 19 ; 28, 31) étant branchées en série et la borne de source d'un premier transistor parmi les transistors à effet de champ à canal n (19 ; 31) étant reliée à la masse,
les voies de charge des transistors à effet de champ à canal p (14, 16 ; 24, 27) étant branchées en série et la borne de source d'un premier transistor parmi les transistors à effet de champ à canal p (14 ; 24) étant reliée à la borne de tension d'alimentation (2) et
les bornes de drain du premier transistor à effet de champ à canal p (14 ; 24) et du second transistor à effet de champ à canal n (17 ; 28) des deux circuits série étant reliées à un premier noeud du circuit et les bornes de drain du second transistor à effet de champ à canal p (16 ; 27) et du premier transistor à effet de champ à canal n (19 ; 31) des circuits série étant reliées à un second noeud du circuit,
caractérisé par le fait que
- les circuits série des transistors à effet de champ à canal n et à canal p du circuit de retard sont formés avec au moins à chaque fois un autre transistor à effet de champ (15, 18 25, 26, 29, 30) du type de canal correspondant, les voies de charge des autres transistors à effet de champ étant branchées respectivement entre les voies de charge des deux transistors à effet de champ à canal p ou à canal n et les bornes de drain d'une paire des autres transistors à effet de champ de type de canal n et p étant envoyées respectivement à un autre noeud du circuit,
- les bornes de grille des autres transistors à effet de champ (15, 18 ; 25, 26, 29, 30) étant reliées à l'entrée (1),
- un étage d'attaque (9) étant prévu, lequel étage d'attaque est branché entre le circuit de retard et l'étage final de puissance (7, 8),
- l'étage d'attaque (9) étant constitué d'étages amplificateurs (20, 21, 22, 23 ; 32 ... 39) qui sont composés respectivement de deux transistors à effet de champ complémentaires dont les voies de charge sont branchées en série entre la borne de tension d'alimentation (2) et la borne de masse (4) et dont le circuit série est muni d'une prise médiane, les prises médianes étant reliées respectivement à une des première et seconde sorties (5, 6) du circuit de commande,
- chaque transistor à effet de champ de chaque étage amplificateur est commandé respectivement par un noeud de circuit différent parmi les premier, second et autres noeuds de circuit, de telle sorte que, lors de la commutation des transistors à effet de champ de chaque étage amplificateur et de l'étage final de puissance, le transistor à effet de champ qui était conducteur à l'instant de commutation est d'abord commuté à l'état bloquant, puis le transistor à effet de champ qui était bloquant à l'instant de commutation est commuté à l'état conducteur.

2. Circuit amplificateur CMOS exempt de courant transversal selon la revendication 1, caractérisé par le fait que, dans l'étage d'attaque (9), la borne de grille du transistor à effet de champ à canal p d'un étage amplificateur est reliée à la borne de drain d'un transistor à effet de champ à canal n du circuit de retard (3) et la borne de grille du transistor à effet de champ à canal n du même étage amplificateur est reliée à la borne de source du transistor à effet de champ à canal n mentionné ci-dessus.

3. Circuit amplificateur CMOS exempt de courant transversal selon la revendication 2, caractérisé par le fait que respectivement deux sorties de l'étage d'attaque (9) sont reliées aux entrées d'un autre étage d'attaque (40 ... 43) branché en aval.
